Europäisches Patentamt

European Patent Office

Office européen des brevets

(11) Publication number: **0 444 650 A2**

# EUROPEAN PATENT APPLICATION

(21) Application number: **91102959.3**

(22) Date of filing: **27.02.91**

(51) Int. Cl.5: **H03L 7/183**

(30) Priority: **28.02.90 JP 45555/90**

(43) Date of publication of application:
**04.09.91 Bulletin 91/36**

(84) Designated Contracting States:
**DE FR GB IT NL SE**

(71) Applicant: **NEC CORPORATION**
**7-1, Shiba 5-chome Minato-ku**
**Tokyo 108-01(JP)**

(72) Inventor: **Watanabe, Nozomu, c/o NEC**
**Corporation**
**7-1, Shiba 5-chome**
**Minato-ku, Tokyo(JP)**

(74) Representative: **Vossius & Partner**
**Siebertstrasse 4 P.O. Box 86 07 67**
**W-8000 München 86(DE)**

(54) **Phase-locked loop type frequency synthesizer having improved loop response.**

(57) A frequency synthesizer using a phase-locked loop is disclosed. The frequency synthesis is accomplished by a closed loop arrangement which includes a digital phase detector, a fixed frequency divider with a divide value Nvd, a direct digital synthesizer, a loop filter (low-pass filter) and a voltage controlled oscillator. The direct digital synthesizer (DDS) produces a signal whose frequency is defined by a first preset frequency (Fd0) and a second preset frequency (δFd) multiplied by a suitable variable coefficient (m). The output frequency of the frequency synthesizer is determined by (Nvd·Fd0 + Nvd·δFd·m).

FIG.2

EP 0 444 650 A2

The present invention relates to a frequency synthesizer using a phase-locked loop. More specifically, the present invention relates to such a phase-locked loop type frequency synthesizer which features a quick loop response even when frequency separation of the output signals is narrowed.

A frequency synthesizer is a combination of circuit functions which generates, or synthesize, many output signals from only a few input signals. Preferably, only one input signal is required and typically, a single output signal out of several hundreds or thousand possibilities is generated at a time.

A phase-locked loop (PLL) offers an ideal solution to frequency synthesis. The PLL is essentially a closed loop electronic servomechanism whose output is locked onto, and will track, a reference signal. This is accomplished using three basic elements: a phase detector, a loop filter (low-pass filter), and a voltage controlled oscillator (VCO). A reference signal also is required as a second input to the phase detector.

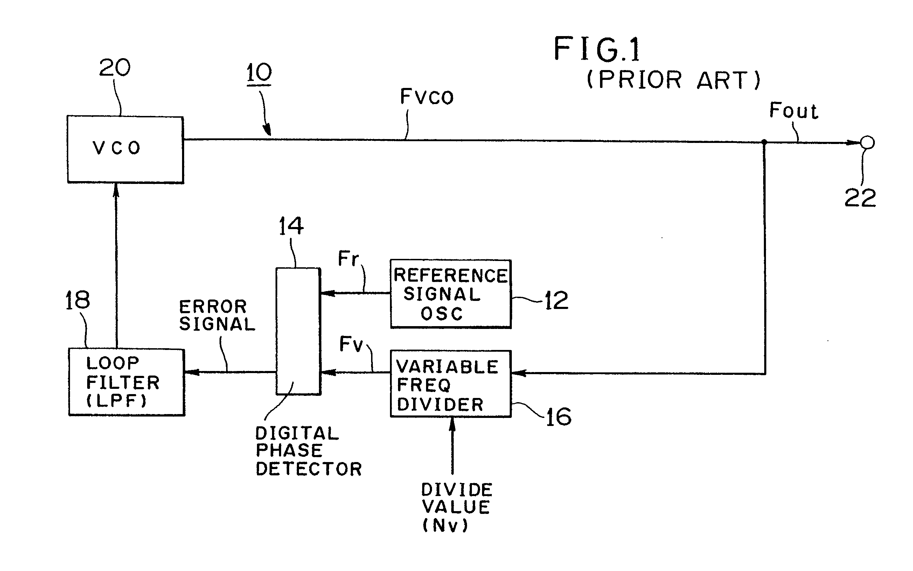

Before turning to the present invention it is deemed advantageous to discuss a typical conventional frequency synthesizer using a PLL with reference to Fig. 1.

It should be noted that, throughout the instant specification, each signal and corresponding frequency thereof will be denoted by corresponding reference characters for the sake of convenience.

As shown in Fig. 1, a known frequency synthesizer 10 comprises a reference signal oscillator 12 which generates a reference signal Fr of suitable frequency accuracy and stability to satisfy system requirements. The reference signal Fr is fed to a digital phase detector 14 which also receives a signal Fv from a variable frequency divider 16. The digital phase detector 14 compares the phases of the two signals Fr and Fv, and generates an error signal which is proportional to the phase difference between said two signals Fr and Fv. The error signal is filtered by a loop filter (low-pass filter) 18 to smooth and shape it into a voltage suitable for controlling a VCO 20. When the output of the loop filter 18 is applied to the VCO 20, the output frequency Fvco of the VCO 20 is induced to change in a direction to establish a constant phase difference (typically "zero") between the two signals Fr and Fv. The output signal Fvco of the VCO 20 is also the output Fout of the synthesizer 10 and is applied to external circuitry (not shown) through an output terminal 22. The signal Fvco is split and fed back to the variable frequency divider 16. It is typical to use a programmable counter as the variable frequency divider 16.

Let it be assumed that a divide value of the variable frequency divider 16 is Nv, then the relationship expressed in following equation is obtained in the case of a "locked condition".

$$Fout = Fr \cdot Nv \quad (1)$$

Accordingly, the output frequency Fout is maintained at a frequency equal to (Fr·Nv) in a "locked condition" of the synthesizer 10. The divide value Nv can be changed by programming a counter (not shown) included in the divider 16 and thus a host of output signals with different frequencies is possible. Each output signal of the frequency synthesizer 10 appears individually and is separated in frequency from an adjacent frequency by an amount equal to the reference signal frequency Fr. The amount of frequency separation is also referred to as "channel spacing".

It will be understood from equation (1) that, if the channel spacing (viz., Fr) is narrowed while maintaining the output frequency Fout high, the divide value Nv should be increased.

However, if the divide value Nv is increased, the following problems are undesirably invited with the conventional frequency synthesizer shown in Fig. 1.

That is to say, an open loop gain of a PLL type frequency synthesizer is lowered in that the open loop gain is inversely proportional to the divide value Nv. This leads to narrowing of a frequency range within which the synthesizer 10 can be pulled into a "locked condition". Consequently, a loop response of the frequency synthesizer 10 is reduced. In other words, in the case where the output frequency of the synthesizer is high and the channel spacing is narrow, the known frequency synthesizer has encountered the difficulties in that a switching time for changing output frequencies is increased.

Further, the digital phase detector 14 compares the two signals Fr and Fv applied thereto at time points each of which is separated from the adjacent ones by 1/Fr (seconds). Accordingly, in the event that the channel spacing (viz., Fr) is narrowed, the sampling interval undesirably increases and hence, the arrangement shown in Fig. 1 has encountered the same difficulties as mentioned above, viz., the slow switching time for changing output frequencies.

## SUMMARY OF THE INVENTION

It is an object of the present invention to provide a frequency synthesizer using a phase-locked loop which features a quick loop response even when channel spacing of the output signals is narrowed while maintaining the output frequency high.

Another object of the present invention is to provide a frequency synthesizer using a direct digital synthesizer as a reference signal oscillator in order to overcome the above-mentioned prior art problems.

In brief, the above objects are achieved by a frequency synthesizer using a phase-locked loop. The frequency synthesis is accomplished by a closed loop arrangement which includes a digital phase detector, a fixed frequency divider with a divide value Nvd, a direct digital synthesizer, a loop filter (low-pass filter) and a voltage controlled oscillator. The direct digital synthesizer (DDS) produces a signal whose frequency is defined by a first preset frequency (Fd0) and a second preset frequency ($\delta$Fd) multiplied by a suitable variable coefficient (m). The output frequency of the frequency synthesizer is determined by (Nvd$\cdot$Fd0 + Nvd$\cdot$$\delta$Fd$\cdot$m).

A first aspect of the present invention comes in a frequency synthesizer using a phase-locked loop, comprising: a frequency synthesizer using a phase-locked loop and producing an output signal whose frequency is variable with a predetermined channel spacing, the frequency synthesizer comprising: first means, the first means receiving a first signal and dividing the frequency of the first signal by a predetermined divide value (denoted by Nvd) and outputting a second signal; second means, the second means generating a third signal; third means, the third means being coupled to receive the second and third signals and comparing phases thereof and generating an error signal indicative of the phase comparison result; and fourth means, the fourth means being coupled to receive the error signal and generating a fourth signal which is controlled in frequency by the error signal and which is derived as an output of the frequency synthesizer, the fourth signal being applied to the first means as the first signal, wherein the third signal has a frequency which is defined by a first predetermined frequency (denoted by Fd0) plus a second predetermined frequency (denoted by $\delta$Fd) multiplied by m (where m = 0, 1, 2, $\cdots$, n (n is a positive integer)), and wherein the output frequency of the frequency synthesizer is determined by Nvd$\cdot$Fd0 with the channel spacing of Nvd$\cdot$$\delta$Fd.

## BRIEF DESCRIPTION OF THE DRAWINGS

The features and advantages of the present invention will become more clearly appreciated from the following description taken in conjunction with the accompanying drawings in which like elements are denoted by like reference numerals and in which:

Fig. 1 is a block diagram showing a known frequency synthesizer using a PLL, Fig. 1 having been referred to in the opening paragraphs of the instant specification;

Fig. 2 is a block diagram showing a preferred embodiment of the present invention; and

Fig. 3 is a block diagram showing in detail one block in the Fig. 2 arrangement.

## DETAILED DESCRIPTION OF THE PREFERRED EMBODIMENTS

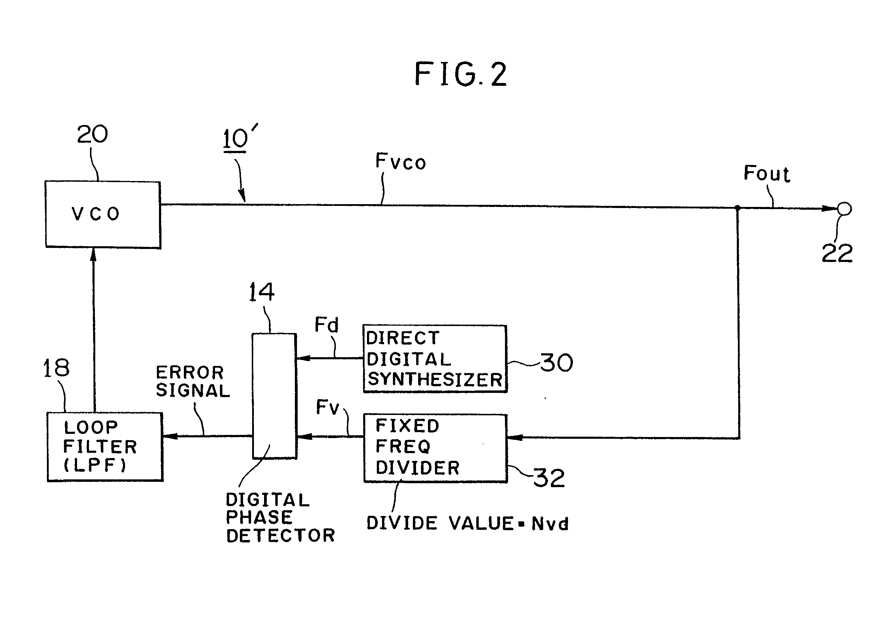

A preferred embodiment of this invention will be described with reference to Fig. 2.

The embodiment features a provision of a direct digital synthesizer 30 in lieu of the reference signal oscillator 12 shown in Fig. 1. Correspondingly, the variable frequency divider 16 (Fig. 1) is replaced with a fixed frequency divider 32. The remaining portions of the Fig. 2 arrangement are exactly the same as those of the Fig. 1 arrangement and hence the descriptions thereof will be omitted for the sake of brevity. A frequency synthesizer illustrated in Fig. 2 is depicted by reference numeral 10'.

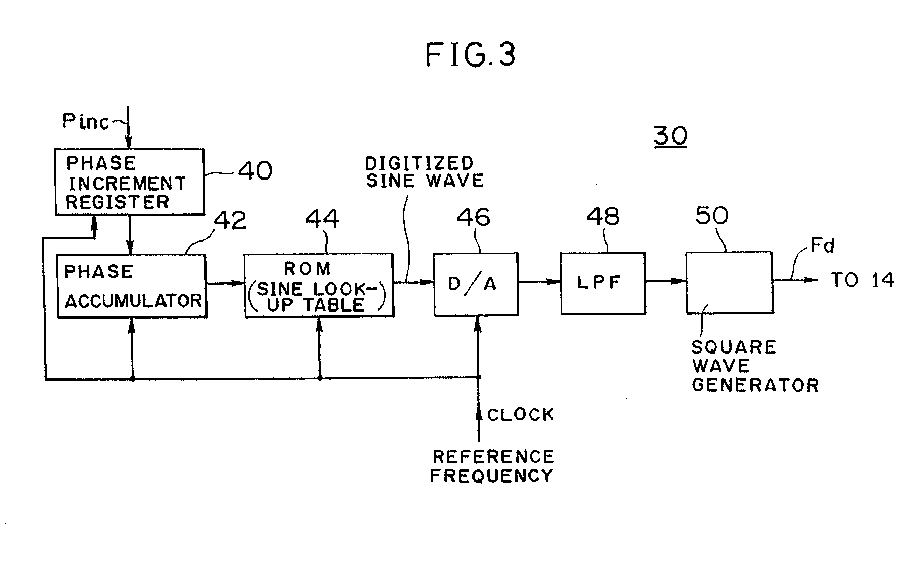

The direct digital synthesizer 30 is a conventional one and will be discussed later with reference to Fig. 3.

It can be seen from equation (1) that the relationship expressed in the following equation (2) is obtained when the synthesizer 10' is in a "locked" condition.

$$Fout = Nvd\cdot Fd \qquad (2)$$

where Nvd is a fixed divide value of the divider 32, and Fd denotes a frequency of a reference signal outputted from the direct digital synthesizer 30. It is assumed that Fd is variable with a frequency spacing $\delta$Fd, then the following equation is given

$$Fd = Fd0 + \delta Fd\cdot m \qquad (3)$$
$$(m = 0, 1, 2, 3, \cdots, n)$$

where Fd0 is a predetermined fixed frequency. Therefore, substituting equation (3) into (2) yields

$$\begin{aligned}
Fout &= Nvd\cdot Fd \\
&= Nvd (Fd0 + \delta Fd\cdot m) \\
&= Nvd\cdot Fd0 + Nvd\cdot\delta Fd\cdot m \qquad (4)
\end{aligned}$$

Designating Nvd$\cdot$Fd0 by Fout0 (constant) and Nvd$\cdot$$\delta$Fd by $\delta$Fout, then equation (4) is rearranged by

$$Fout = Fout0 + \delta Fout\cdot m \qquad (5)$$

This means that the output (Fout) of the frequency synthesizer 10' has a channel spacing of $\delta$Fout.

Before referring to the features of the present invention, reference will be made to Fig. 3 which illustrates in detail an example of the direct digital synthesizer 30.

It is known in the art that a direct digital synthesizer works on the principle that a digitized waveform of a given frequency can be generated by accumulating phase changes at a higher frequency.

As shown in Fig. 3, the direct digital synthesizer 30 includes a phase increment register 40 which receives a phase increment value Pinc from a suitable controller (not shown) and stores same therein. The value stored in the phase increment register 40 is added to the value in a phase accumulator 42 once during each clock period of a reference frequency. The resulting phase value (from 0 to full-scale) is applied to a ROM 44 which pre-stores a sine lookup table and, is converted therein to the corresponding digitized value of the sine wave using the lookup. This digital value is applied to a digital-to-analog (D/A) converter 46. The output of the D/A converter 46 has the desired sine wave as a major component, but also includes the higher frequency image components. A low-pass filter 48 is used to reduce these image signals to a desired level. A square wave generator 50 is supplied with the output of the low-pass filter 48 and applies the square wave signal with a desired frequency to the digital phase comparator 14 (Fig. 2). It should be noted that the square wave generator 50 may be omitted if the detector 14 (Fig. 2) is provided with a circuit by which a sine wave signal applied from the low-pass filter 48 is shaped into a rectagular waveform.

The direct digital synthesizer 30 features a very fast frequency change in the order of few nanoseconds. Further, the frequency resolution can be increased without difficulty by increasing the bit resolution of the phase accumulator 42.

It is assumed that the output frequency (Fd) of the direct digital synthesizer 30 is very high relative to the channel spacing ($\delta$Fout). That is to say,

$$\delta Fout << Fd \qquad (6)$$

It is further assumed that the channel spacing ($\delta$Fout) is equal to the channel spacing (Fr) of the Fig. 1 arrangement, then, we obtain the following equation using equations (1) and (6)

$$Nvd << Nv \qquad (7)$$

Accordingly, it is understood that even in the case where $\delta$Fout << Fout, the fixed divide value Nvd can be set to a very low value as compared with Nv. In this instance, the direct digital synthesizer 10' is required to have a frequency resolution of $\delta$Fout/Nvd (= $\delta$Fd).

For a better understanding of the present invention, the frequency synthesizer 10' is assumed to generate an output which ranges from 900 MHz to 902 MHz with a channel spacing 20 KHz by way of example. In this instance, the following equation is given

$$Fout = 900 \text{ (MHz)} + 20 \text{ (kHz)}^{\bullet}m \qquad (8)$$
$$(m = 0, 1, 2, {}^{\bullet\bullet\bullet}, 99, 100)$$

This means that

$$Nvd^{\bullet}Fdo = 900 \text{ (MHz)}$$
$$Nvd^{\bullet}\delta Fd = 20 \text{ (KHz)}$$

In the even that Nvd is set to 400 (for example), Fdo = 2.25 (MHz) and $\delta$Fd = 50 (Hz) and hence

$$Fd = 2.25 \text{ (MHz)} + 50 \text{ (Hz)} \qquad (9)$$

The direct digital synthesizer whose output Fd satisfies equation (9), is commercially available. It goes without saying that the fixed divide value Nvd should be selected considering the maximum available frequency of the direct digital synthesizer 30. By contrast, the divide value Nv of the Fig. 1 arrangement should be 45,000 in order to produce an synthesizer's output of 900 MHz (m=0). It is understood that according to the present invention the divide value Nvd can be set to a very small value as compared with Nv.

As previously mentioned, the direct digital synthesizer 30 features a very fast frequency change in the order of few nanoseconds. Accordingly, a very quick loop response can be attained together with the low value of Nvd.

The frequency divider 32 has been discussed as a fixed type. However, it is within the scope of the present invention to provide a variable type frequency divider in place of the above-mentioned divider 32, and accordingly, more flexible control of the channel spacing can be expected.

While the foregoing description describes one embodiment according to the present invention, the various alternatives and modifications possible without departing from the scope of the present invention, which is limited only by the appended claims, will be apparent to those skilled in the art.

## Claims

1. A frequency synthesizer using a phase-locked loop and producing an output signal whose frequency is variable with a predetermined channel spacing, said frequency synthesizer comprising:

    first means, said first means receiving a first signal and dividing the frequency of said first signal by a predetermined divide value (denoted by Nvd) and outputting a second signal;

second means, said second means generating a third signal;

third means, said third means being coupled to receive said second and third signals and comparing phases thereof and generating an error signal indicative of the phase comparison result; and

fourth means, said fourth means being coupled to receive said error signal and generating a fourth signal which is controlled in frequency by said error signal and which is derived as an output of said frequency synthesizer, said fourth signal being applied to said first means as said first signal,

wherein said third signal has a frequency which is defined by a first predetermined frequency (denoted by Fd0) plus a second predetermined frequency (denoted by $\delta$Fd) multiplied by m (where m = 0, 1, 2, $\cdots$, n (n is a positive integer)), and wherein the output frequency of said frequency synthesizer is determined by Nvd$\cdot$Fd0 with the channel spacing of Nvd$\cdot\delta$Fd.

2. A frequency synthesizer as claimed in claim 1, wherein said second means is a direct digital synthesizer.

3. A frequency synthesizer as claimed in claim 1 or 2, wherein said second means comprises:

a phase increment register, said phase increment register receiving a given phase value and storing same therein;

a phase accumulator, said phase accumulator being coupled to receive said given phase value and accumulating same up to a predetermined value;

a non-volatile memory, said non-volatile memory being arranged to receive the accumulated value from said phase accumulator, said non-volatile memory pre-storing a sine lookup table and outputting a digital sine wave signal using the lookup table in response to the accumulated values applied thereto;

a digital-to-analog converter, said digital-to-analog converter being coupled to convert said digital sine wave signal to the corresponding analog signal; and

a low-pass filter, said low-path filter being coupled to receive the analog signal from said digital-to-analog converter and producing a filtered analog signal which is applied to said second means.

4. A frequency synthesizer as claimed in claim 3, further comprising a square wave generator which is preceded by said low-pass filter.

5. A frequency synthesizer comprising: voltage-controlled oscillator (VCO) means for generating an oscillation signal and changing the frequency thereof in response to an error signal;

frequency divider means for frequency dividing said oscillation signal to produce a frequency divided signal;

direct digital synthesizer means for digitally generating a synthesized signal and changing the frequency thereof in response to a control signal; and

phase detector means for comparing the phases of said frequency divided and synthesized signals to produce a phase difference therebetween and supplying a signal representative of said phase difference to said VCO means as said error signal.

6. A method of producing an output signal whose signal is variable with a control signal, comprising the steps of:

generating an oscillation signal as said output signal;

frequency dividing said oscillation signal to produce a frequency divided signal;

generating a synthesized signal with a direct digital synthesizer;

changing the frequency of said synthesized signal in response to said control signal;

comparing the phases of said frequency divided and synthesized signals to produce a phase difference therebetween; and

changing the frequency of said oscillation signal in response to said phase difference.

# FIG.1
(PRIOR ART)

EP 0 444 650 A2

FIG.2

# FIG.3

EP 0 444 650 A2